# FASCICULE DE BREVET EUROPEEN

(11) **EP 3 155 684 B1**
(45) Date de publication et mention de la délivrance du brevet: **21.11.2018**
(21) Numéro de dépôt: 15747388.5
(22) Date de dépôt: 16.06.2015
(51) Int. Cl.: H01M 10/052, H01G 9/035, H01G 11/58, H01G 11/62, H01B 1/12, H01M 10/0568

(54) **LIQUIDE IONIQUE SPECIFIQUE ET PROCEDE DE PREPARATION DE CELUI-CI**
SPEZIFISCHE IONENFLÜSSIGKEIT UND VERFAHREN ZUR HERSTELLUNG DAVON
SPECIFIC IONIC LIQUID AND METHOD FOR PRODUCING SAME

(30) Priorité: 16.06.2014 FR 1455489
(43) Date de publication de la demande: 19.04.2017
(73) Titulaire: Commissariat à l'Énergie Atomique et aux Énergies Alternatives, 75015 Paris (FR); Université François Rabelais, 37041 Tours Cedex 1 (FR)
(72) Inventeur: GALIANO, Hervé, F-37700 La Ville aux Dames (FR); ANOUTI, Mériem, F-37550 Saint Avertin (FR)
(74) Mandataire: Brevalex
(86) Numéro de dépôt international: PCT/EP2015/063449
(87) Numéro de publication internationale: WO 2015/193293

(56) Documents cités:
- EP-A1- 2 388 853
- US-A1- 2011 143 196
- LI MINGTAO ET AL: "Polymer gel electrolytes containing sulfur-based ionic liquids in lithium battery applications at room temperature", JOURNAL OF APPLIED ELECTROCHEMISTRY, SPRINGER, DORDRECHT, NL, vol. 43, no. 5, 21 février 2013 (2013-02-21), pages 515-521, XP035305769, ISSN: 0021-891X, DOI: 10.1007/S10800-013-0535-4 [extrait le 2013-02-21]
- KOEN BINNEMANS: "Ionic Liquid Crystals", CHEMICAL REVIEWS, vol. 105, no. 11, 1 novembre 2005 (2005-11-01), pages 4148-4204, XP055167497, ISSN: 0009-2665, DOI: 10.1021/cr0400919

## Description

### DOMAINE TECHNIQUE

La présente invention a trait à de nouveaux liquides ioniques résultant de l'association entre un cation spécifique et un anion spécifique, ces liquides ioniques présentant de bonnes propriétés de conductivité, une faible viscosité ainsi qu'un large domaine d'électroactivité.

C'est donc tout naturellement que ces liquides ioniques peuvent trouver application comme électrolytes dans des dispositifs à stockage d'énergie, tels que les batteries lithium-soufre ou encore dans des dispositifs solaires, tels que les cellules solaires à pigment photosensible.

Les liquides ioniques sont des sels se présentant à l'état liquide à température ambiante, ces liquides ioniques pouvant être représentés par la formule générale suivante :

A⁺X⁻

dans laquelle :
*A⁺ représente un cation généralement organique; et
*X⁻ représente un anion organique ou minéral.

Idéalement, ils n'ont pas de tension de vapeur mesurable et présentent une grande stabilité thermique, ce qui induit que les problèmes environnementaux et de sécurité rencontrés avec les solvants organiques (que ce soit en termes de volatilité, d'évaporation et de risques d'inflammabilité ou d'explosion) sont éliminés avec eux. Ils peuvent ainsi être qualifiés de solvants verts.

Toutefois, les liquides ioniques peuvent présenter une viscosité importante et donc des conductivités ioniques faibles, ce qui entraîne des résistances élevées à température ambiante.

Ces inconvénients peuvent être surmontés, au moins en partie, en utilisant des liquides ioniques protiques, notamment ceux issus d'une réaction de transfert de protons entre un acide et une base de BrØnsted. Du fait de la possibilité de jouer sur la nature des acides et bases mis en jeu dans la réaction de transfert, ces liquides ioniques peuvent montrer, notamment des propriétés modulables en termes de viscosité et de conductivité, ce qui les prédispose pour entrer dans la constitution d'électrolytes conducteurs de protons adaptés notamment pour être utilisés dans une large gamme de températures d'utilisation.

Le document EP 2388853 a trait à des liquides ioniques consistant en un couple comprenant un anion sulfure/polysulfure et un cation organique, lesquels liquides ioniques servant d'électrolytes redox dans des dispositifs électrochimiques et/ou optoélectroniques.

Au vu de ce qui existe déjà, les auteurs de la présente invention ont mis au point une nouvelle classe de liquides ioniques, qui répondent notamment également aux caractéristiques mentionnées ci-dessus et, qui plus est, permettent d'obtenir des densités de puissance et des densités d'énergie importantes, lorsqu'ils sont utilisés comme électrolytes dans des dispositifs de stockage d'énergie.

### EXPOSÉ DE L'INVENTION

Ces nouveaux liquides ioniques comprennent ainsi, l'association d'un cation de formule (I) suivante : 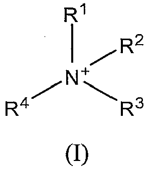 et d'un anion choisi parmi les anions de formules (IV) et (V) suivantes : 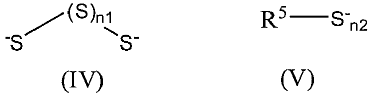 dans lesquelles :
- R¹ à R⁴ représentent, indépendamment l'un de l'autre, un atome d'hydrogène ou un groupe hydrocarboné, aliphatique ou cyclique, à condition que l'un au moins des groupes R¹ à R⁴ représente un groupe hydrocarboné aliphatique comprenant au moins deux atomes de carbone et l'un au moins des groupes R¹ à R⁴ représente un atome d'hydrogène ;
- R⁵ est un groupe hydrocarboné cyclique ;
- n1 est un entier égal à 1, 2, 3, 4, 5 ou 6 ; et
- n2 est un entier égal à 1, 2, 3 ou 4.

Ainsi, le liquide ionique de l'invention est un liquide ionique, dans lequel le cation est un cation de formule (I) et l'anion est un anion de formule (IV) ou un anion de formule (V) tels que définis ci-dessus.

Tout en respectant les conditions mentionnées ci-dessus, lorsque les groupes R¹ à R⁴ correspondent à un groupe hydrocarboné aliphatique, il peut s'agir d'un groupe alkyle.

Plus spécifiquement, tout en respectant les conditions mentionnées ci-dessus, lorsque les groupes R¹ à R⁴ correspondent à un groupe hydrocarboné aliphatique, il peut s'agir d'un groupe hydrocarboné aliphatique comprenant au moins deux atomes de carbone, tel qu'un groupe alkyle.

Plus spécifiquement encore, le groupe hydrocarboné aliphatique comprenant au moins deux atomes de carbone peut être un groupe hydrocarboné, linéaire ou ramifié, comprenant de 2 à 16 atomes de carbone, tel qu'un groupe alkyle, par exemple, un groupe alkyle de formule CH₃-(CH₂)ₙ- avec n étant un entier allant de 1 à 15 (par exemple, un groupe n-octyle).

De façon plus particulière, au moins deux des groupes R¹ à R⁴ sont des groupes hydrocarbonés aliphatiques comprenant au moins deux atomes de carbone tels que définis ci-dessus et au moins un des groupes R¹ à R⁴ est un atome d'hydrogène, un exemple spécifique tombant sous le coup de cette définition étant le cation dioctylammonium de formule (VII) suivante :

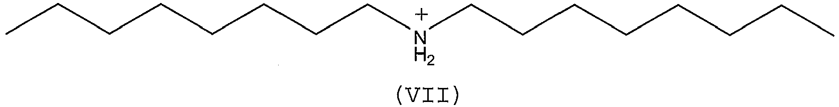

Comme mentionné plus haut, R¹ à R⁴ peuvent représenter un groupe hydrocarboné cyclique, au même titre que R⁵ représente un groupe hydrocarboné cyclique, sous réserve, bien entendu que les conditions énoncées ci-dessus relatives aux groupes R¹ à R⁴ soient respectées.

On entend, classiquement, par « groupe hydrocarboné cyclique », tout groupe hydrocarboné, saturé ou insaturé, qui est formé d'un ou plusieurs cycles hydrocarbonés, le ou les cycles comprenant au moins 3 atomes de carbone.

Quand il s'agit d'un groupe hydrocarboné cyclique saturé, il peut s'agir d'un groupe cyclopropyle, cyclobutyle, cyclo-pentyle, cyclohexyle, bicyclohexyle, bicyclodécyle, etc.

Quand il s'agit d'un groupe hydrocarboné cyclique insaturé, il peut s'agir d'un groupe aromatique et plus spécifiquement d'un groupe aryle.

On entend, classiquement, par « groupe aryle », un groupe monocyclique ou polycyclique qui satisfait à la règle de Hückel, c'est-à-dire qui présente un nombre d'électrons π délocalisés égal à 4n + 2 (avec n = 0, 1, 2, 3,...), ce groupe pouvant comporter au moins 5 atomes de carbone, par exemple, de 5 à 18 atomes de carbone. A titre d'exemples de groupe aryle susceptible d'être utilisé, on peut citer les groupes cyclopentadiényle, phényle, benzyle, biphényle, pyrényle, naphtalényle, phénantrényle et anthracényle.

Le groupe hydrocarboné cyclique, tel qu'un groupe aromatique, peut être éventuellement substitué, ce qui signifie, en d'autres termes, qu'un ou plusieurs atomes d'hydrogène porté(s) par le ou les cycles est (sont) remplacé(s) par des groupes, qui peuvent être choisis, par exemple, parmi les atomes d'halogène, les groupes alcool, éther, amine, acide carboxylique, ester, nitrile, amide, nitro, thiol, thioester, silyle, phosphine ou phosphoryle.

Plus spécifiquement, R⁵ peut être un groupe phényle, tel qu'un groupe phényle éventuellement substitué, par exemple, par au moins un groupe nitro -NO₂.

A titre d'exemple, l'anion peut être un anion de formule (VI) suivante : 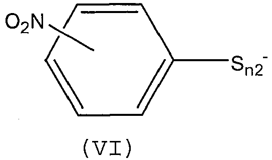 avec n2 étant tel que défini ci-dessus, par exemple n2 étant égal à 1 ou 2.

Lorsque l'anion tombe sous le coup de la définition des anions de formule (IV) ci-dessus, il peut répondre à la formule spécifique S₄²⁻.

A titre d'exemple, un liquide ionique conforme à l'invention est un liquide ionique, dans lequel le cation répond la formule (VII) telle que définie ci-dessus et dans lequel l'anion est un anion de formule S₄²⁻ ou de formule (VI) telles que définies ci-dessus.

Ces liquides ioniques peuvent être utilisés seuls ou en mélange avec au moins un solvant organique, pour former un électrolyte.

Dans le cas où le liquide ionique est utilisé en mélange avec au moins un solvant organique, l'invention se réfère ainsi à une composition comprenant au moins un liquide ionique tel que défini ci-dessus et au moins un solvant organique.

Le cas échéant, le solvant organique peut être choisi parmi les nitriles, les alcools, les amides, les carbonates linéaires, les carbonates cycliques.

Plus spécifiquement, le solvant organique peut être un solvant amide, tel que le diméthylacétamide.

En outre, les compositions de l'invention peuvent comprendre un sel de lithium.

A titre d'exemples, le sel de lithium peut être choisi dans le groupe constitué par LiPF₆, LiClO₄, LiBF₄, LiAsF₆, LiCF₃SO₃, LiN(CF₃SO₂)₃, LiN(C₂F₅SO₂), le bis(trifluorométhylsulfonyl)imide de lithium (connu sous l'abréviation LiTFSI) LiN[SO₂CF₃]₂, le bis(oxalato)borate de lithium (connu sous l'abréviation LIBOB), le bis(fluorosulfonyl)imide de lithium (connu sous l'abréviation LiFSI), LiPF₃(CF₂CF₃)₃ (connu sous l'abréviation LiFAP), le trifluorométhanesulfonate de lithium (connu sous l'abréviation LiTf), le bis-trifluorométhanesulfonylimide de lithium (connu sous l'abréviation Lilm) et les mélanges de ceux-ci.

Le sel de lithium peut être compris, dans l'électrolyte, à une concentration allant jusqu'à 5 M, par exemple 1M.

Dans les compositions de l'invention, le liquide ionique susmentionné peut être présent en une quantité d'au moins 10% massique par rapport à la masse totale de la composition et peut aller jusqu'à 85% massique par rapport à la masse totale de la composition.

A titre d'exemple, une composition comprenant, comme liquide ionique, le liquide ionique de formule [(C₈H₁₇)₂N⁺H₂]₂S₄²⁻ et en concentration de 4*10⁻² mol/L dans le diméthylacétamide présente une bonne conductivité de 1,8 mS/cm à 25°C et une faible viscosité de 2,7 mPa.s à 25°C.

Cette composition présente également un large domaine d'électroactivité, par exemple, allant jusqu'à 3,6 V sur électrode de platine et jusqu'à 2 V sur électrode en carbone activé.

De manière plus générale, les compositions de l'invention à base d'un solvant diméthylacétamide peuvent présenter un caractère ionique avec des conductivités pouvant aller de 1,8 mS/cm à 25°C à 10 mS/cm à 80°C et une viscosité de 1,7 mPa.s à 80°C à 2,7 mPa.s à 25°C.

Les liquides ioniques de l'invention et les compositions les comprenant peuvent être préparés par une méthode originale impliquant notamment l'utilisation d'un liquide ionique intermédiaire présentant des capacités réductrices et structurantes, apte notamment à réduire le soufre ou les composés disulfures organiques pour former des liquides ioniques conformes à l'invention.

Ainsi l'invention a trait à un procédé de préparation d'un liquide ionique tel que défini ci-dessus ou d'une composition telle que définie ci-dessus, ledit procédé comprenant les étapes suivantes :
a) une étape de réaction :
   *d'un liquide ionique intermédiaire comprenant l'association :
      - d'un cation choisi de formules (I) suivante : 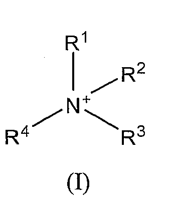 dans lesquelles :
         - R¹ à R⁴
            sont tels que définis ci-dessus, c'est-à-dire que R¹ à R⁴
            représentent, indépendamment l'un de l'autre, un atome d'hydrogène ou un groupe hydrocarboné, aliphatique ou cyclique, à condition que l'un au moins des groupes R¹ à R⁴
            représente un groupe hydrocarboné aliphatique comprenant au moins deux atomes de carbone et l'un au moins des groupes R¹ à R⁴
            représente un atome d'hydrogène ; et
         - d'un anion apte à réduire le soufre S₈ ou un composé de formule R₅-S-S-R⁵, R⁵ étant tel que défini ci-dessus, ledit anion pouvant être choisi parmi les anions formate, acétate, tartrate, ascorbate ou oxalate ;
   *avec du soufre S₈ ou un composé de formule R⁵-S-S-R⁵, R⁵ étant tel que défini ci-dessus,
   moyennant quoi l'on obtient un liquide ionique comprenant l'association d'un cation de formule (I) que définies ci-dessus et d'un anion de formule (IV) ou (V) telles que définies ci-dessus, avec n2 étant égal à 1 ;
b) lorsque l'on souhaite obtenir un liquide ionique ou une composition comprenant celui-ci, lequel liquide ionique comprend l'association d'un cation de formule (I) et d'un anion de formule (V), avec n2 étant égal à 2, une étape supplémentaire de réaction du liquide ionique obtenu à l'étape a) avec du soufre S₈, étant entendu que le liquide ionique obtenu à l'étape a) est celui obtenu avec le composé de formule R⁵-S-S-R⁵.

Ainsi, lorsque l'on souhaite obtenir un liquide ionique comprenant l'association d'un cation de formule (I) et d'un anion de formule (IV), il s'agit, selon le procédé de l'invention, de faire réagir, avec du soufre S₈, un liquide ionique intermédiaire comprenant l'association d'un cation de formules (I) définie ci-dessus et d'un anion tel que défini ci-dessus, à savoir un anion pouvant être choisi parmi les anions formate, acétate, tartrate, ascorbate, oxalate.

La réaction susmentionnée, en prenant, pour exemple, un cation de formule [R₂NH₂]⁺, peut être schématisée par l'équation chimique suivante :

8[R₂NH₂⁺] [HCOO⁻] + 2S₈ → 4 [R₂NH₂⁺]₂[S₄²⁻] + 8CO₂ + 4H₂

La réaction peut être réalisée en présence d'un solvant organique, tel que ceux mentionnés ci-dessus, auquel cas l'issue de la réaction est une composition comprenant le liquide ionique conforme à l'invention.

Lorsque l'on souhaite obtenir un liquide ionique comprenant l'association d'un cation de formule (I) et d'un anion de formule (V) avec n₂ égal à 1, il s'agit, selon le procédé de l'invention, de faire réagir, avec un composé R⁵-S-S-R⁵, un liquide ionique intermédiaire comprenant l'association d'un cation de formule (I) définies ci-dessus et d'un anion réducteur tel que défini ci-dessus, par exemple, choisi parmi les anions formate, acétate, tartrate, ascorbate, oxalate.

La réaction susmentionnée, en prenant, pour exemple, un cation de formule [R₂NH₂]⁺, peut être schématisée par l'équation chimique suivante :

2 [R₂NH₂⁺] [HCOO⁻] + R⁵-S-S-R⁵ → 2 [R₂NH₂⁺] [R-⁵S⁻] + 2CO₂ + H₂

La réaction peut être, également, réalisée en présence d'un solvant organique, tel que ceux mentionnés ci-dessus, auquel cas l'issue de la réaction est une composition comprenant le liquide ionique conforme à l'invention.

Enfin, lorsque l'on souhaite obtenir un liquide ionique comprenant l'association d'un cation de formule (I) et d'un anion de formule (V) avec n2 égal à 2, le procédé comprend, en outre, après l'étape a), la mise en oeuvre d'une étape supplémentaire b), consistant à faire réagir, avec du soufre, le liquide ionique issu de l'étape a), à savoir le liquide ionique comprenant l'association d'un cation de formule (I) et d'un anion de formule (V) avec n2 égal à 1.

La réaction susmentionnée peut être schématisée par l'équation chimique suivante :

[R₂NH₂⁺][R⁵S⁻] + (1/8)S₈ → [R₂NH₂⁺][R⁵S₂⁻]

Selon le procédé de l'invention, le liquide ionique intermédiaire susmentionné peut être préparé préalablement.

Par exemple, ce liquide ionique intermédiaire peut être préalablement préparé par une simple réaction acido-basique selon le mécanisme de BrØnsted entre un acide de BrØnsted (par exemple, l'acide formique, l'acide acétique, l'acide tartrique, l'acide ascorbique, l'acide oxalique) et une base de BrØnsted dont la protonation fournit les cations de formule (I) susmentionnée.

Ainsi, ce type de liquide ionique intermédiaire constitue un liquide ionique protonique, qui est utilisé comme milieu réducteur pour le soufre ou pour les composés disulfures susmentionnés.

Généralement, les liquides ioniques intermédiaires du type mentionné ci-dessus peuvent présenter une structure de phase lamellaire et un aspect extérieur de gel, moyennant quoi l'anion, qui présente des propriétés réductrices, est immobilisé et voit ainsi son pouvoir réducteur exacerbé.

Dès lors que le liquide ionique intermédiaire est mis en contact avec du soufre ou un composé disulfure tel que défini ci-dessus, il conduit, avantageusement, à une réduction stoechiométrique du soufre ou du composé disulfure et forme ainsi un liquide ionique conforme à l'invention.

Eu égard aux propriétés susmentionnées notamment en termes de conductivité et de viscosité, les liquides ioniques de l'invention et les compositions les comprenant sont à même de pouvoir être utilisés comme électrolytes, en particulier, dans un dispositif à stockage d'énergie, par exemple, un accumulateur lithium-soufre ou encore une cellule solaire.

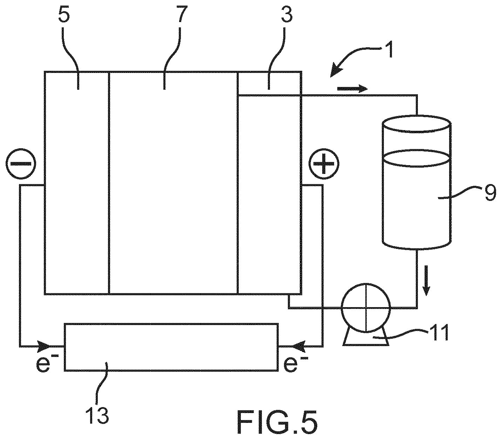

L'invention a donc trait également à un dispositif à stockage d'énergie, par exemple, du type accumulateur lithium-soufre, comme illustré selon un mode de réalisation particulier sur la figure 5 jointe en annexe, comprenant une cellule 1 comprenant une électrode positive 3 et une électrode négative 5 séparées l'une de l'autre par un séparateur 7 comprenant, comme électrolyte, un liquide ionique ou une composition conforme à l'invention. En outre, la cellule peut être reliée à un réservoir 9, qui permet, via une pompe 11, l'acheminement du liquide ionique ou de la composition conforme à l'invention au niveau du séparateur. La cellule est également reliée à un chargeur 13 pour effectuer les opérations de charge.

L'électrode positive peut être à base d'un matériau composite carbone/soufre et l'électrode négative peut être à base d'un matériau lithié, par exemple, un matériau à base d'oxyde (s) métallique (s), tel que Li₄Ti₅O₁₂.

L'invention va à présent être décrite en référence aux exemples fournis ci-dessous donnés à titre illustratif et non limitatif.

### BRÈVE DESCRIPTION DES DESSINS

Les figures 1 et 2 correspondent à des voltammogrammes réalisés respectivement avec le premier dispositif et le deuxième dispositif de l'exemple 2.
La figure 3 est un diagramme de Ragone illustrant le positionnement d'un des accumulateurs préparés à l'exemple 6.
La figure 4 est un graphique illustrant l'évolution du potentiel E (en V) (exprimé par rapport à une électrode en argent) par rapport au temps (en heures) lors d'essais galvanostatiques réalisés avec l'un des accumulateurs préparés à l'exemple 6.
La figure 5 est une vue en coupe d'un accumulateur lithium-soufre particulier conforme à l'invention.

### EXPOSÉ DÉTAILLÉ DE MODES DE RÉALISATION PARTICULIERS

### EXEMPLE 1

Cet exemple illustre la synthèse d'un liquide ionique spécifique (le formate de dioctylammonium, dénommé sous l'abréviation DOAF), ce liquide ionique étant utilisé ensuite comme agent réducteur du soufre ou de composés disulfures organiques pour la fabrication d'un liquide ionique conforme à l'invention.

Le formate de dioactylammonium (DOAF) répond à la formule suivante :

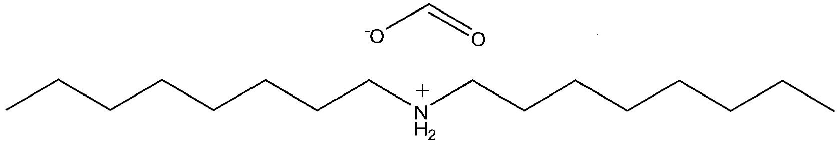

Ce liquide ionique est synthétisé par réaction stoechiométrique de la dioctylamine (241 g, 1 mole) avec de l'acide formique (47 g, 1 mole), moyennant quoi il se forme un composé blanc légèrement jaune présentant un aspect de gel correspondant au formate de dioctylammonium.

Le rendement d'obtention est proche de 99%.

### EXEMPLE 2

Cet exemple illustre la synthèse d'un liquide ionique conforme à l'invention : un polysulfure de dioctylammonium (DOAPS).

Pour ce faire, il est préparé, dans un premier temps, une solution par mélange stoechiométrique de diméthylacétamide (à raison de 75% en masse par rapport à la masse totale de la solution) et du liquide ionique préparé à l'exemple 1 ci-dessus (à raison de 25% en masse par rapport à la masse totale de la solution).

La solution résultante est homogénéisée par agitation sous ultrasons pendant 15 minutes, moyennant quoi l'on obtient une solution jaune liquide visqueuse.

A cette solution est ajouté du soufre solide. Le mélange est agité et soumis à des ultrasons et devient rouge vif.

En symbolisant le formate de dioctylammonium par la formule [R₂NH₂]⁺[HCOO]⁻ (avec R correspondant ainsi à un groupe n-octyle), la réaction de synthèse peut être illustrée par l'équation chimique suivante :

8 [R₂NH₂⁺][HCOO⁻] + 2S₈ → 4 [R₂NH₂⁺]₂[S₄²⁻] + 8CO₂ + 4H₂

Au vu de l'équation chimique ci-dessus, il apparaît que cette réaction ne génère aucun produit secondaire, en ce sens que, outre, le polysulfure de dioctylammonium, seuls des produits volatils sont formés (respectivement du dioxyde de carbone et de l'hydrogène).

Il résulte ainsi uniquement une solution de polysulfure de dioctylammonium fortement concentrée dans du diméthylacétamide.

Cette solution présente une couleur rouge vif, cette couleur pouvant être attribuée à l'absorption à 500 nm des ions S₈²⁻, étape initiale de la réduction du soufre conformément à l'équation chimique (2S₈ + 4e⁻ → 2S₈²⁻). Conformément à une réduction électrochimique, l'évolution naturelle de cette étape initiale est le passage par la dismutation des ions S₈²⁻ puis une deuxième étape de réduction pour former les ions S₄²⁻ conformément à l'équation chimique (2S₈²⁻ + 4e⁻ → 4S₄²⁻).

La solution susmentionnée est soumise à une" caractérisation électrochimique avec deux dispositifs électrochimiques distincts :
- un premier dispositif à trois électrodes comprenant, respectivement, une électrode carbone/soufre, une électrode de pseudo-référence consistant en un fil d'argent et une contre-électrode en lithium ;
- un deuxième dispositif à trois électrodes comprenant, respectivement, deux électrodes en carbone activé et une électrode de référence se présentant sous forme d'un fil d'argent,
la solution susmentionnée constituant l'électrolyte pour ces deux dispositifs.

L'électrolyte a été soumis, pour chacun de ces dispositifs, à un test de voltampérométrie cyclique en système swagelock, les résultats de ce test étant reportés respectivement :

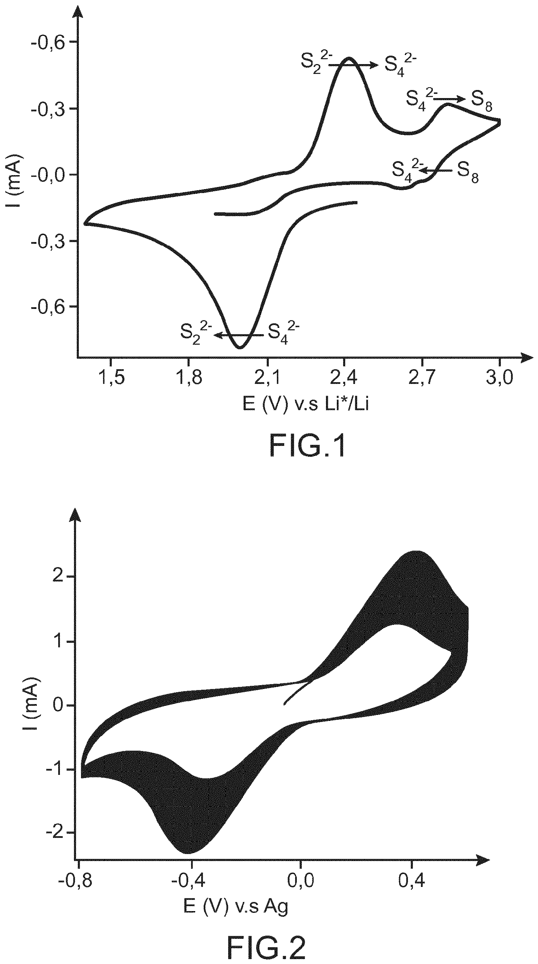

- sur la figure 1 pour le premier dispositif, illustrant un voltammogramme entre 1,4 V et 3 V vs. Li⁺/Li ; et
- sur la figure 2 pour le deuxième dispositif, illustrant un voltammogramme entre -0,8 et 0,6 V par rapport à l'électrode de pseudo-référence en argent.

Le voltammogramme obtenu avec le premier dispositif est caractéristique des ions polysulfures S₄²⁻ stables dans le liquide ionique.

Le voltammograme obtenu avec le deuxième dispositif atteste d'un dépôt de soufre dans la porosité du carbone visible par la diminution progressive des pics cathodique et anodique, ce qui peut permettre d'envisager d'utiliser ce protocole pour fabriquer une électrode composite carbone/soufre.

### EXEMPLE 3

Cet exemple illustre la synthèse d'un liquide ionique conforme à l'invention : le 4-nitrophénylthiolate de dioctylammonium pouvant être symbolisé par la formule [(C₈H₁₇)₂NH₂]⁺[4-NO₂PhS]⁻.

Pour ce faire, il est préparé, dans un premier temps, une solution par mélange stoechiométrique de diméthylacétamide (à raison de 75% en masse par rapport à la masse totale de la solution) et du liquide ionique préparé à l'exemple 1 ci-dessus (à raison de 25% en masse par rapport à la masse totale de la solution), soit 10 g de mélange obtenu par 2, 5 g de liquide ionique susmentionné et 7,5 g de diméthylacétamide.

La solution résultante est homogénéisée par agitation sous ultrasons pendant 15 minutes, moyennant quoi l'on obtient une solution jaune liquide visqueuse.

A cette solution est ajoutée une quantité stoechiométrique de 4-nitrophényldisulfure, soit 1,34 g de ce composé pour 10 g de solution. Le mélange est agité et soumis à des ultrasons et devient rouge vif.

En symbolisant le formate de dioctylammonium par la formule [R₂NH₂]⁺[HCOO]⁻ et le 4-nitrophényldisulfure par la formule R⁵-S-S-R⁵, la réaction de synthèse peut être illustrée par l'équation chimique suivante :

2[R₂NH₂⁺][HCOO⁻] + R⁵-S-S-R⁵ → 2 [R₂NH₂⁺][R⁵S⁻] + 2CO₂ + H₂

### EXEMPLE 4

Cet exemple illustre la synthèse d'un liquide ionique conforme à l'invention : le 2-nitrophénylthiolate de dioctylammonium pouvant être symbolisé par la formule [(C₈H₁₇)₂NH₂]⁺[2-NO₂PhS]⁻.

Pour ce faire, il est préparé, dans un premier temps, une solution par mélange stoechiométrique de diméthylacétamide (à raison de 75% en masse par rapport à la masse totale de la solution) et du liquide ionique préparé à l'exemple 1 ci-dessus (à raison de 25% en masse par rapport à la masse totale de la solution), soit 10 g de mélange obtenu par 2,5 g de liquide ionique susmentionné et 7,5 g de diméthylacétamide.

La solution résultante est homogénéisée par agitation sous ultrasons pendant 15 minutes, moyennant quoi l'on obtient une solution jaune liquide visqueuse.

A cette solution est ajoutée une quantité stoechiométrique de 2-nitrophényldisulfure. Le mélange est agité et soumis à des ultrasons et devient bleue intense.

En symbolisant le formate de dioctylammonium par la formule [R₂NH₂]⁺[HCOO]⁻ et le 2-nitrophényldisulfure par la formule R⁵-S-S-R⁵, la réaction de synthèse peut être illustrée par l'équation chimique suivante :

2[R₂NH₂⁺] [HCOO⁻] + R⁵-S-S-R⁵ → 2 [R₂NH₂⁺] [R⁵S⁻] + 2CO₂ + H₂

Sous l'effet de la lumière (en particulier UV), la solution se décolore au bout de 1 à 2 minutes d'exposition.

Sans sollicitation UV et à l'abri de la lumière, la solution se recolore au bout de 8 à 10 minutes.

### EXEMPLE 5

Cet exemple illustre la synthèse d'un liquide ionique conforme à l'invention : le 4-nitrophényldithiolate de dioctylammonium pouvant être symbolisé par la formule [(C₈H₁₇)₂NH₂]⁺[4-NO₂PhS₂]⁻.

Ce liquide ionique est obtenu par ajout de de soufre S₈ dans le liquide ionique obtenu à l'exemple 3.

Plus spécifiquement, il est ajouté, à 10 g de liquide ionique obtenu à l'exemple 3, 0,139 g de soufre S₈ suivi d'un traitement par sonication, moyennant quoi l'on obtient le 4-nitrophényldithiolate de dioctylammonium.

En symbolisant le 4-nitrophénylthiolate de dioctylammonium par la formule [(C₈H₁₇)₂NH₂]⁺[4-NO₂PhS]⁻ la réaction de synthèse peut être illustrée par l'équation chimique suivante :

[(C₈H₁₇)₂NH₂]⁺[4-NO₂PhS]⁻ + 1/8 S₈ → [(C₈H₁₇)₂NH₂]⁺[4-NO₂PhS₂]⁻

En solution dans le diméthylacétamide, le liquide ionique présente une variation de couleur en fonction du temps.

### EXEMPLE 6

Dans cet exemple, le liquide ionique préparé à l'exemple 2 (DOAPS) est mis en oeuvre comme électrolyte dans des accumulateurs du type carbone/soufre.

Chaque accumulateur comprend une seule cellule comportant une électrode positive carbone/soufre et une électrode négative comprenant, comme matériau actif, du Li₄Ti₅O₁₂.

Pour fabriquer l'électrode positive carbone/soufre, on procède au mélange de 10 g de soufre S₈, 15 g de noir de carbone et 5 g de polyfluorure de vinylidène. Après mélangeage, on ajoute 30 g d'acétone, puis après homogénéisation et évaporation de l'acétone jusqu'à obtention d'une solution visqueuse, le mélange est coulé sur banc d'enduction selon une épaisseur de 500 micromètres environ puis sécher à température ambiante jusqu'à obtention d'un film autosupporté. Le film est ensuite découpé sous forme de disques de 1 cm de diamètre pour servir d'électrode positive. Il est isolé, un disque présentant une quantité de soufre de 32 mg (pour constituer l'électrode positive de l'accumulateur du premier test mentionné ci-dessous) et un disque présentant une quantité de soufre de 18 mg (pour constituer l'électrode positive de l'accumulateur du deuxième test mentionné ci-dessous).

L'électrode négative, que ce soit pour le premier test ou le deuxième test, est une électrode commerciale se présentant sous forme d'une pastille comprenant 85% de matériau actif, 10% de noir d'acétylène et 10% de polyfluorure de vinylidène, avec un collecteur en cuivre.

Pour former un accumulateur, l'électrode positive et l'électrode négative sont séparées par un séparateur Watman imbibé du liquide ionique préparé à l'exemple 2, auquel a été ajouté du LiTFSI 1 M, soit une mole de LiTFSI pour un litre de liquide ionique susmentionné.

Avec les accumulateurs résultants, des tests ont été réalisés en faisant varier notamment le courant appliqué et la tension de travail avec un système swagelock à trois électrodes.

Lors d'un premier test, avec l'accumulateur comprenant une électrode positive, telle que définie ci-dessus, pour laquelle la teneur en soufre est de 32 mg, lorsque l'on impose un courant de -60 mA en charge et de +60 mA en décharge, le système cycle entre -0,35 V et +0,65 V (soit une différence de potentiel de 1 V) avec un régime de charge/décharge de 1 heure (soit un régime C).

De ces valeurs, il est possible de caractériser l'accumulateur en densités de puissance et de densité d'énergie, lesquelles sont respectivement, pour ce premier test, de 1,8 kW/kg et de 1,8 kWh/kg.

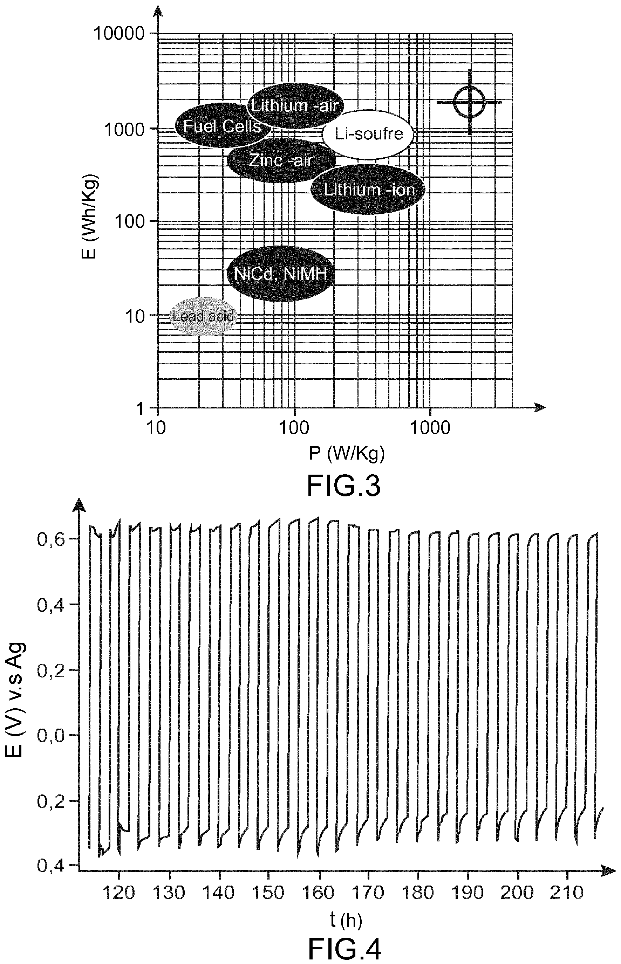

A partir de ces valeurs, l'on peut positionner l'accumulateur sur un diagramme de Ragone, qui représente, pour différents systèmes, l'évolution de la densité d'énergie gravimétrique E (en Wh/kg) en fonction de la densité de puissance P (en W/kg). Ce diagramme a pour visée de comparer l'accumulateur de l'invention avec d'autres systèmes de stockage de l'énergie électrique, comme les accumulateurs lithium-ion, lithium-air, lithium-soufre, zinc-air, les piles à combustibles (dites « Fuel Cells » sur le diagramme), les piles NiCd, NiMH ou plomb-acide (dites « Lead-acid » sur le diagramme) comme illustré sur la figure 3 jointe en annexe. Il apparaît clairement que l'accumulateur du premier test présente une densité de puissance et une densité d'énergie supérieures aux systèmes de stockage de l'énergie électrique tels que listés ci-dessus.

Lors d'un deuxième test, avec l'accumulateur comprenant une électrode positive, telle que définie ci-dessus, pour laquelle la teneur en soufre est de 18 mg, lorsque l'on impose un courant de -24 mA en charge et de +24 mA en décharge, le système cycle entre -0,35 V et +0,65 V (soit une différence de potentiel de 1 V) avec un régime de charge/décharge C/2.

De ces valeurs, il est possible de caractériser l'accumulateur en termes de densités de puissance et de densité d'énergie, lesquelles sont respectivement, pour ce deuxième test, de 1,2 kW/kg et de 2,4 kWh/kg, ce qui permet de placer l'accumulateur du deuxième test au-dessus des systèmes de stockage listés ci-dessus en termes de performances.

D'autre part, avec l'accumulateur du deuxième test, il a pu être démontrer, lors d'essais galvanostatiques, qu'il présente une cyclabilité et une efficience remarquables avec plus de 5000 cycles sans perte de capacités, comme l'atteste la figure 4 jointe en annexe, cette figure illustrant l'évolution du potentiel E (en V) (exprimé par rapport à un électrode en argent) par rapport au temps (en heures).

En résumé, avec les accumulateurs, les avantages se révèlent nombreux :
- ils sont d'un coût faible et sont simples à concevoir ;
- ils présentent de fortes densités de puissance et de fortes densités d'énergie supérieures à de nombreux systèmes de stockage de l'énergie électrique ;
- ils présentent une cyclabilité et une efficience remarquables ; et
- ils peuvent supporter de forts régimes de charge (tels que C/5, C/2, C, 2C, 5C).

## Revendications

1. Liquide ionique comprenant l'association d'un cation formule (I) suivante : 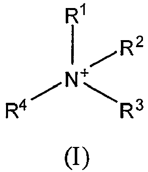 et d'un anion choisi parmi les anions de formules (IV) et (V) suivantes : 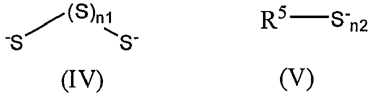 dans lesquelles :
- R¹ à R⁴ représentent, indépendamment l'un de l'autre, un atome d'hydrogène ou un groupe hydrocarboné, aliphatique ou cyclique, à condition que l'un au moins des groupes R¹ à R⁴ représente un groupe hydrocarboné aliphatique comprenant au moins deux atomes de carbone et l'un au moins des groupes R¹ à R⁴ représente un atome d'hydrogène ;
- R⁵ est un groupe hydrocarboné cyclique ;
- n1 est un entier égal à 1, 2, 3, 4, 5 ou 6 ; et
- n2 est un entier égal à 1, 2, 3 ou 4.

2. Liquide ionique selon la revendication 1, dans lequel le cation répond à la formule (I) telle que définie à la revendication 1 et l'anion répond à la formule (IV) telle que définie à la revendication 1.

3. Liquide ionique selon la revendication 1, dans lequel le cation répond à la formule (I) telle que définie à la revendication 1 et l'anion répond à la formule (V) telle que définie à la revendication 1.

4. Liquide ionique selon l'une quelconque des revendications précédentes, dans lequel, lorsque les groupes R¹ à R⁴ correspondent à un groupe hydrocarboné aliphatique, ils correspondent à un groupe hydrocarboné aliphatique comprenant au moins deux atomes de carbone.

5. Liquide ionique selon l'une quelconque des revendications précédentes, dans lequel au moins deux des groupes R¹ à R⁴ sont des groupes hydrocarbonés aliphatiques comprenant au moins deux atomes de carbone tels que définis selon l'une quelconque des revendications précédentes et au moins un des groupes R¹ à R⁴ est un atome d'hydrogène.

6. Liquide ionique selon l'une quelconque des revendications précédentes, dans lequel le cation est un cation de formule (VII) suivante :

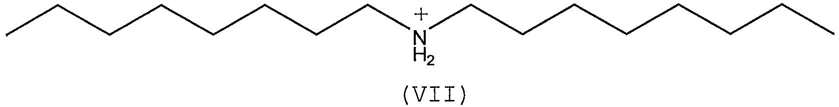

7. Liquide ionique selon l'une quelconque des revendications précédentes, dans lequel R⁵ est un groupe aromatique.

8. Liquide ionique selon l'une quelconque des revendications précédentes, dans lequel l'anion est un anion de formule S₄²⁻.

9. Liquide ionique selon l'une quelconque des revendications 1 à 7, dans lequel l'anion est un anion de formule (VI) suivante : 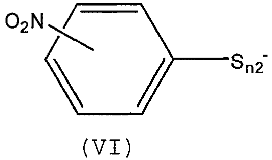 avec n2 étant tel que défini à la revendication 1.

10. Liquide ionique selon l'une quelconque des revendications précédentes, qui est un électrolyte.

11. Composition comprenant au moins un liquide ionique tel que défini selon l'une quelconque des revendications 1 à 10 et au moins un solvant organique.

12. Composition selon la revendication 11, qui est un électrolyte.

13. Procédé de préparation d'un liquide ionique tel que défini selon l'une quelconque des revendications 1 à 10 ou d'une composition telle que définie selon l'une quelconque des revendications 11 à 12, ledit procédé comprenant les étapes suivantes :
a) une étape de réaction :
*d'un liquide ionique intermédiaire comprenant l'association :
- d'un cation de formule (I) suivante : 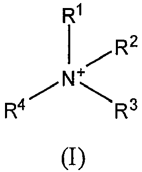 telle que définie à la revendication 1; et
- d'un anion apte à réduire le soufre S₈ ou un composé de formule R₅-S-S-R⁵, R⁵ étant tel que défini à la revendication 1 ;
*avec du soufre S₈ ou un composé de formule R⁵-S-S-R⁵, R⁵ étant tel que défini ci-dessus,
moyennant quoi l'on obtient un liquide ionique comprenant l'association d'un cation de formule (I) telle que définie ci-dessus et d'un anion de formule (IV) ou (V) telles que définies ci-dessus, avec n2 étant égal à 1 ;
b) lorsque l'on souhaite obtenir un liquide ionique ou une composition comprenant celui-ci, lequel liquide ionique comprend l'association d'un cation de formule (I) et d'un anion de formule (V), avec n2 étant égal à 2, une étape supplémentaire de réaction du liquide ionique obtenu à l'étape a) avec du soufre S₈, étant entendu que le liquide ionique obtenu à l'étape a) est celui obtenu avec le composé de formule R⁵-S-S-R⁵.

14. Dispositif à stockage d'énergie comprenant au moins une cellule comprenant une électrode positive et une électrode négative séparées l'une de l'autre par un séparateur comprenant, comme électrolyte, un liquide ionique tel que défini à la revendication 10 ou une composition telle que définie à la revendication 12.

15. Cellule solaire comprenant, comme électrolyte, un liquide ionique tel que défini à la revendication 10 ou une composition telle que définie à la revendication 12.

## Patentansprüche

1. Ionische Flüssigkeit umfassend die Assoziation aus einem Kation der folgenden Formel (I): 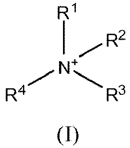 und einem Anion, ausgewählt aus den Anionen der folgenden Formeln (IV) und (V): 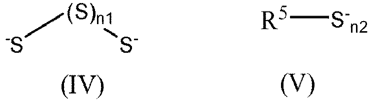 wobei:
- R¹ bis R⁴ unabhängig voneinander ein Wasserstoffatom oder eine aliphatische oder zyklische Kohlenwasserstoffgruppe darstellen, mit der Maßgabe, dass mindestens eine der Gruppen R¹ bis R⁴ eine aliphatische Kohlenwasserstoffgruppe umfassend mindestens zwei Kohlenstoffatome darstellt und dass mindestens eine der Gruppen R¹ bis R⁴ ein Wasserstoffatom darstellt;
- R⁵ eine zyklische Kohlenwasserstoffgruppe ist;
- n1 eine ganze Zahl gleich 1, 2, 3, 4, 5 oder 6 ist; und
- n2 eine ganze Zahl gleich 1, 2, 3 oder 4 ist.

2. Ionische Flüssigkeit gemäß Anspruch 1, wobei das Kation der Formel (I) entspricht, wie in Anspruch 1 definiert, und das Anion der Formel (IV) entspricht, wie in Anspruch 1 definiert.

3. Ionische Flüssigkeit gemäß Anspruch 1, wobei das Kation der Formel (I) entspricht, wie in Anspruch 1 definiert, und das Anion der Formel (V) entspricht, wie in Anspruch 1 definiert.

4. Ionische Flüssigkeit gemäß einem der vorhergehenden Ansprüche, wobei, wenn die Gruppen R¹ bis R⁴ eine Kohlenwasserstoffgruppe darstellen, sie eine aliphatische Kohlenwasserstoffgruppe umfassend mindestens zwei Kohlenstoffatome darstellen.

5. Ionische Flüssigkeit gemäß einem der vorhergehenden Ansprüche, wobei mindestens zwei der Gruppen R¹ bis R⁴ aliphatische Kohlenwasserstoffgruppen umfassend mindestens zwei Kohlenstoffatome sind, wie in einem der vorhergenenden Ansprüche definiert, und mindestens eine der Gruppen R¹ bis R⁴ ein Wasserstoffatom ist.

6. Ionische Flüssigkeit gemäß einem der vorhergehenden Ansprüche, wobei das Kation ein Kation der folgenden Formel (VII) ist:

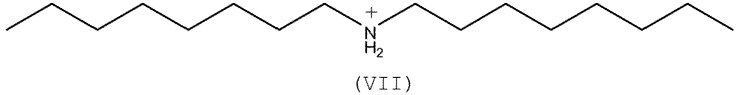

7. Ionische Flüssigkeit gemäß einem der vorhergehenden Ansprüche, wobei R⁵ eine aromatische Gruppe ist.

8. Ionische Flüssigkeit gemäß einem der vorhergehenden Ansprüche, wobei das Anion ein Anion der Formel S₄²⁻ ist.

9. Ionische Flüssigkeit gemäß einem der Ansprüche 1 bis 7, wobei das Anion ein Anion der folgenden Formel (VI) ist: 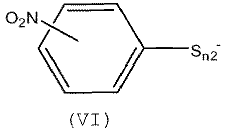 wobei n2 wie in Anspruch 1 definiert ist.

10. Ionische Flüssigkeit gemäß einem der vorhergehenden Ansprüche, welche ein Elektrolyt ist.

11. Zusammensetzung umfassend mindestens eine ionische Flüssigkeit, wie gemäß einem der Ansprüche 1 bis 10 definiert, und mindestens ein organisches Lösungsmittel.

12. Zusammensetzung gemäß Anspruch 11, welche ein Elektrolyt ist.

13. Verfahren zur Herstellung einer ionischen Flüssigkeit, wie gemäß einem der Ansprüche 1 bis 10 definiert, oder einer Zusammensetzung, wie gemäß einem der Ansprüche 11 bis 12 definiert, wobei das Verfahren die folgenden Schritte umfasst:
a) einen Schritt der Umsetzung:
* einer intermediären ionischen Flüssigkeit umfassend die Assoziation:
- aus einem Kation der folgenden Formel (I): 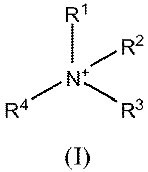 wie in Anspruch 1 definiert;
- aus einem Anion, das dazu geeignet ist, Schwefel S₈ oder eine Verbindung der Formel R⁵-S-S-R⁵, wobei R⁵ wie in Anspruch 1 definiert ist, zu reduzieren;
• mit Schwefel S₈ oder einer Verbindung der Formel R⁵-S-S-R⁵, wobei R⁵ wie oben definiert ist,
wodurch eine ionische Flüssigkeit umfassend die Assoziation aus einem Kation der Formel (I), wie oben definiert, und einem Anion der Formel (IV) oder (V), wie oben definiert, mit n2 gleich 1, erhalten wird;
b) wenn es gewünscht ist, eine ionische Flüssigkeit oder eine Zusammensetzung, welche diese umfasst, zu erhalten, wobei die ionische Flüssigkeit die Assoziation aus einem Kation der Formel (I) und einem Anion der Formel (V), wobei n2 gleich 2 ist, umfasst, einen zusätzlichen Schritt der Umsetzung der in Schritt a) erhaltenen Flüssigkeit mit Schwefel S₈, wobei es sich versteht, dass die in Schritt a) erhaltene ionische Flüssigkeit diejenige ist, die mit der Verbindung der Formel R⁵-S-S-R⁵ erhalten wird.

14. Vorrichtung zur Speicherung von Energie umfassend mindestens eine Zelle, die eine positive und eine negative Elektrode umfasst, die voneinander durch einen Separator, welcher als Elektrolyt eine ionische Flüssigkeit, wie in Anspruch 10 definiert, oder eine Zusammensetzung, wie in Anspruch 12 definiert, umfasst, getrennt sind.

15. Solarzelle umfassend als Elektrolyt eine ionische Flüssigkeit, wie in Anspruch 10 definiert, oder eine Zusammensetzung, wie in Anspruch 12 definiert.

## Claims

1. An ionic liquid comprising the association of a cation selected from among cations of following formula (I): 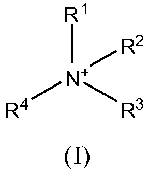 with an anion selected from among the anions of following formulas (IV) and (V): 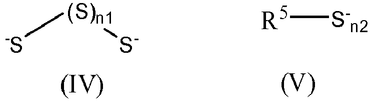 where:
- R¹ to R⁴ are each independently a hydrogen atom or an aliphatic or cyclic hydrocarbon group, provided that at least one of groups R¹ to R⁴ represents an aliphatic hydrocarbon group having at least two carbon atoms, and at least one of groups R¹ to R⁴ represents a hydrogen atom;
- R⁵ is a cyclic hydrocarbon group;
- n1 is an integer equalling 1, 2, 3, 4, 5 or 6; and
- n2 is an integer equalling 1, 2, 3 or 4.

2. The ionic liquid according to claim 1, wherein the cation meets formula (I) such as defined in claim 1 and the anion meets formula (IV) such as defined in claim 1.

3. The ionic liquid according to claim 1, wherein the cation meets formula (I) such as defined in claim 1 and the anion meets formula (V) such as defined in claim 1.

4. The ionic liquid according to any of the preceding claims, wherein, when the groups R¹ to R⁴ correspond to an aliphatic hydrocarbon group, they correspond to an aliphatic hydrocarbon group having at least two carbon atoms.

5. The ionic liquid according to any of the preceding claims, wherein at least two of groups R¹ to R⁴ are aliphatic hydrocarbon groups having at least two carbon atoms such as defined in any of the preceding claims, and at least one of groups R¹ to R⁴ are a hydrogen atom.

6. The ionic liquid according to any of the preceding claims, wherein the cation is a cation of following formula (VII):

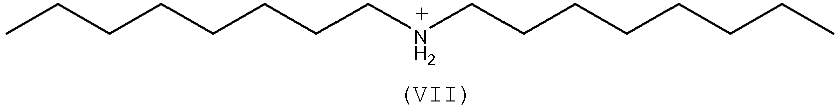

7. The ionic liquid according to any of the preceding claims, wherein R⁵ is an aromatic group.

8. The ionic liquid according to any of the preceding claims, wherein the anion is an anion of formula S₄²⁻.

9. The ionic liquid according to any of claims 1 to 7, wherein the anion is an anion of following formula (VI) : 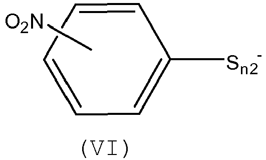 with n2 being such as defined in claim 1.

10. The ionic liquid according to any of the preceding claims, that is an electrolyte.

11. A composition comprising at least one ionic liquid such as defined according to any of claims 1 to 10 and at least one organic solvent.

12. The composition according to claim 11, that is an electrolyte.

13. A method to prepare an ionic liquid such as defined in any of claims 1 to 10, or a composition such as defined in any of claims 11 to 12, said method comprising the following steps:
a) a reaction step:
*of an intermediate ionic liquid comprising the association:
- of a cation of following formula (I): 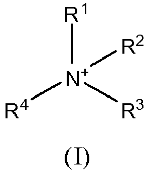 such as defined in claim 1; and
- of an anion capable of reducing sulfur S₈ or a compound of formula R₅-S-S-R⁵, R⁵ being such as defined in claim 1;
*with sulfur S₈ or a compound of formula R⁵-S-S-R⁵, R⁵ being such as defined above,
after which an ionic liquid is obtained comprising the association of a cation of formula (I), such as defined above, and of an anion of formula (IV) or (V) such as defined above, with n2 equalling 1;
b) if it is desired to obtain an ionic liquid or composition comprising the same, said ionic liquid comprising the association of a cation of formula (I), and an anion of formula (V), with n2 equalling 2, an additional reaction step of the ionic liquid obtained at step a) with sulfur S₈ is performed, on the understanding that the ionic liquid obtained at step a) is the one obtained with the compound of formula R⁵-S-S-R⁵.

14. An energy storage device comprising at least one cell comprising a positive electrode and a negative electrode separated from each other by a separator comprising, as electrolyte, an ionic liquid such as defined in claim 10 or a composition such as defined in claim 12.

15. A solar cell comprising, as electrolyte, an ionic liquid such as defined in claim 10 or a composition such as defined in claim 12.
